# EUROPEAN PATENT APPLICATION

(11) **EP 1 566 642 A1**
(43) Date of publication of application: **24.08.2005**
(21) Application number: 05250853.8
(22) Date of filing: 15.02.2005
(51) Int. Cl.: G01R 1/073

(54) **Probe card**

(30) Priority: 23.02.2004 JP 2004045682
(71) Applicant: NIHON DENSHIZAIRYO KABUSHIKI KAISHA, Hyogo 660-0805 (JP)
(72) Inventor: Machida, Kazumichi, Takarazuka-shi, Hyogo, 665-0841 (JP); Urata, Atsuo, Ibaraki-shi, Osaka 567-0023 (JP); Mine, Atsushi, Arao-shi, Kunamoto, 684-0001 (JP)
(74) Representative: Beresford, Keith Denis Lewis

(57) **Abstract**

A probe card according to the invention includes: probes 100 shaped to allow vertical elastic deformation; a supporting substrate 200 with the probes provided on the lower surface thereof; a main substrate 300 positioned opposing the upper surface of the supporting substrate 200; an intermediate substrate 400 disposed between the supporting substrate 200 and main substrate 300; a supporting member 500 that is a column-shaped member with one end thereof attached to the center of the supporting substrate 200 and the other end thereof attached to the intermediate substrate 400 and holds the supporting substrate 200 so that the supporting substrate 200 is inclinable; and elastic members for holding the supporting substrate 200 so that the supporting substrate 200 is in a horizontal position relative to the main substrate 300, which are provided between the supporting substrate 200 and main substrate 300.

## Description

The present invention relates to a probe card used to measure various electrical properties or the like of an object to be measured.

As this kind of probe card, there has been known a probe card comprising: probes that contact the signal electrodes of an object to be measured; a supporting substrate to which the probes are electrically and mechanically connected; a main substrate positioned opposite the upper surface of the supporting substrate; and a connection mechanism for connecting a wiring pattern of the main substrate to a wiring pattern of the supporting substrate.

This probe card, which is mounted on a stage of a prober, is adjusted by an adjusting mechanism of the prober so as to be in a horizontal position, and then is used to measure various electrical properties of an object to be measured by operating the probe. Such an arrangement is shown in Japanese Patent Laid-Open No. 05-144892.

In recent years, the degree of integration of an object to be measured is increasingly rising. With such high integration of an object to be measured, minute variations in height between each signal electrode can pose a problem. The problem of the minute variations in height between each signal electrode can be addressed by allowing each probe of the probe card to elastically deform.

As the degree of integration of an object to be measured rises, apart from the minute variations in height between each signal electrode, a minute inclination of the object to be measured at the time of installation can also pose a problem. When the object to be measured inclines, one part of the signal electrodes will be positioned higher than the other signal electrodes. Consequently, when the probe card is kept in a horizontal position, while one part of the probes can contact one part of the signal electrodes, the remaining probes fail to contact the other signal electrodes, or even if there exists some contact, a predetermined contact pressure needed to achieve the electrical continuity between the probes and signal electrodes can not be obtained, resulting in a failure to properly perform the measurement.

The invention is devised to address the above problems. An object of the invention is to provide a probe card that, even when an object to be measured is in an inclined state, allows all the probes to contact the signal electrodes of the object to be measured and at the same time secures a predetermined contact pressure needed to achieve the electrical continuity between the probes and signal electrodes, thereby making it possible to properly perform the measurement.

A probe card according to the invention includes probes shaped to allow vertical elastic deformation, a supporting substrate with the probes provided on the lower surface thereof, a main substrate positioned opposite the upper surface of the supporting substrate and a column-shaped supporting member that is provided between the supporting substrate and main substrate and holds the supporting substrate such that the supporting substrate is inclinable, wherein one end of the supporting member is disposed at the center of the supporting substrate.

The supporting member preferably has a configuration that allows vertical elastic deformation.

In addition, vertically elastically deformable elastic members are preferably provided at at least two locations between the supporting substrate and main substrate. As the elastic members, ones having a smaller overall spring coefficient than that of the probes are employed.

An intermediate substrate being more rigid than the main substrate can be disposed between the main substrate and supporting substrate. In this case, provided between the intermediate substrate and supporting substrate is the supporting member, or are the supporting member and elastic members.

A wiring pattern electrically connected to the probes is formed inside and/or on the surface of the supporting substrate. A wiring pattern is also formed inside and/or on the surface of the main substrate. The wiring pattern of the supporting substrate is electrically connected via a connecting member to the wiring pattern of the main substrate.

When the main substrate is a flexible substrate, again a wiring pattern electrically connected to the probes is formed inside and/or on the surface of the main substrate. This wiring pattern of the main substrate is electrically connected via a connecting member to the wiring pattern of the supporting substrate.

A reinforcing board is preferably provided on the upper surface of the supporting substrate.

In a probe card according to claim 1 of the invention, even if an object to be measured inclines, when one part of the probes contact one part of the signal electrodes which are positioned higher than the other signal electrodes of the object to be measured, a supporting substrate inclines according to the inclination of the object to be measured around the supporting member, whereby the supporting substrate is positioned parallel to the object to be measured. Accordingly, all the probes contact the signal electrodes of the object to be measured. Thus, when the probes are pressed (overdriven) against the signal electrodes in a conventional way, a predetermined contact pressure needed to achieve the electrical continuity between the probes and signal electrodes can also be obtained. In addition, due to the probes being vertically elastically deformed, minute variations in height between each signal electrode can also be absorbed, thereby making it possible to properly perform the measurement.

In a probe card according to claim 2 of the invention, after the supporting substrate inclines and all the probes contact the signal electrodes of the object to be measured, each of the probes elastically deforms and at the same time the supporting member elastically deforms. Accordingly, a predetermined contact pressure needed to achieve the electrical continuity between the probes and signal electrodes of the object to be measured can be easily obtained, thereby making it possible to more stably perform the measurement.

In a probe card according to claim 3 of the invention, elastic members being vertically elastically deformable and at the same time having a smaller overall spring coefficient than that of the probes are interposed at at least two locations between the main substrate and the supporting substrate. These elastic members work as a parallelism adjusting member between the supporting substrate and the object to be measured when the supporting substrate inclines. Thus, the supporting substrate is prevented from excessively inclining when one part of the probes contacts the signal electrodes of the object to be measured, thereby making it to possible to stably perform the measurement. In this case, the supporting substrate can be more stably held as compared to when the supporting substrate is held by a single supporting member. Thus, there arises no risk that the probes become dislocated from the signal electrodes of the object to be measured.

In a probe card according to claim 4 of the invention, an intermediate substrate being more rigid than the main substrate is disposed between the main substrate and supporting substrate; the supporting member is, or the supporting member and the elastic member are provided between the intermediate substrate and supporting substrate. Accordingly, the intermediate substrate is prevented from being bent by a pushing force exerted through the supporting member and/or elastic members when the probes are brought into contact with the signal electrodes of the object to be measured. Thus, the supporting substrate inclines properly according to the inclination of the object to be measured, thereby making it possible to stably perform the measurement.

In a probe card according to claim 5 of the invention, a wiring pattern connected electrically to the probes is formed inside and/or on the surface of the supporting substrate; therefore the electrical connection to a measurement apparatus can be easily made through the wiring pattern.

In a probe card according to claim 6 of the invention, circuit elements needed to perform the electrical measurement using the probes are disposed in the vicinity of the probes; therefore the probe card is advantageous in that the measurement accuracy can be improved.

In a probe card according to claims 7 and 8 of the invention, a wiring pattern is formed inside and/or on the surface of the main substrate, and the wiring pattern of the main substrate is electrically connected via a connecting member to the wiring pattern of the supporting substrate; therefore the wiring pattern of the supporting substrate, which becomes more congested as the probes are miniaturized, can be dispersed to the main substrate. Accordingly, the probe card is advantageous in that high integration of the object to be measured can be coped with.

In a probe card according to claim 9 of the invention, a reinforcing board is provided on the upper surface of the supporting substrate; therefore the supporting substrate is prevented from being bent by a pushing force exerted through the probes when the probes are brought into contact with the signal electrodes of the object to be measured. Thus, the supporting substrate inclines properly according to the inclination of the object to be measured, thereby making it possible to stably perform the measurement.

Hereinafter, embodiments of the invention will be described by way of example only, with reference to the accompanying drawings in which:
Fig. 1 is a schematic sectional view of a probe card according to a first embodiment of the invention;
Fig. 2 is a schematic plan view of the probe card which shows the arrangement of a supporting member and elastic members;
Fig. 3 is a schematic diagram of probes used in the probe card;
Fig. 4 is a schematic diagram of the probe shown in Fig. 3(a) that is provided with a reinforcing member;
Fig. 5 is an enlarged sectional view of a part α shown in Fig. 1, which shows the probe card with the probe contacting a signal electrode of an object to be measured;
Fig. 6 is a schematic sectional view of the probe card being in operation;
Fig. 7 is a schematic sectional view of a probe card according to a second embodiment of the invention; and
Fig. 8 is a schematic plan view of the probe card which shows the arrangement of a supporting member and elastic members.

### Embodiment 1

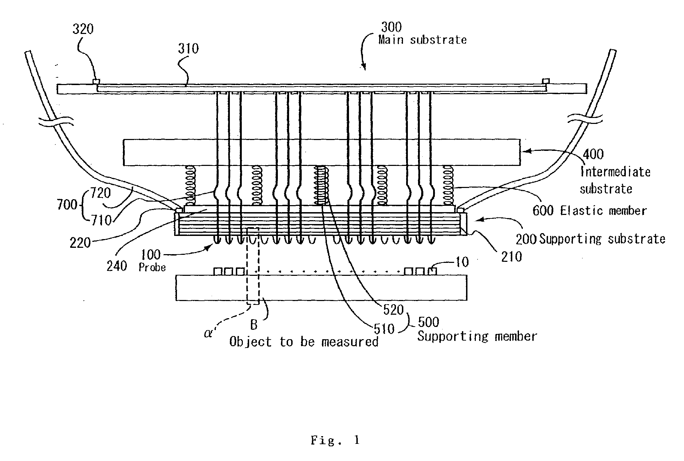

Firstly a probe card according to a first embodiment of the invention will be described with reference to Figs. 1 to 5.

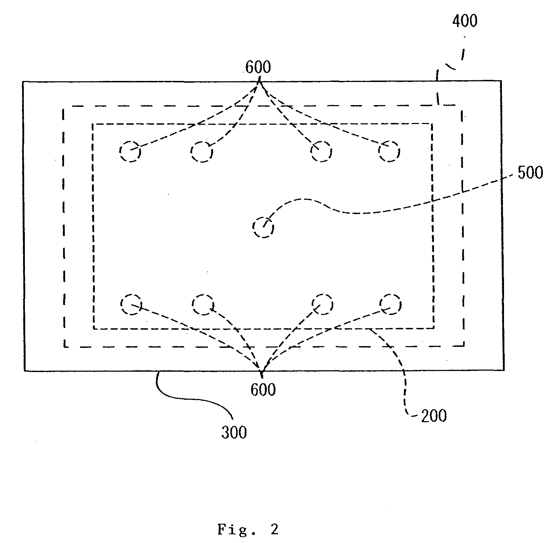

A probe card A shown in Figs. 1 and 2, which is electrically connected to a measurement apparatus (not shown) for measuring various electrical properties of an object B to be measured (a semiconductor wafer) and is used as a sensing part that is mounted on a prober installed in the measurement apparatus, includes a plurality of probes 100, a supporting substrate 200 with the probes 100 provided on the lower surface thereof, a main substrate 300 positioned opposite the upper surface of the supporting substrate 200, an intermediate substrate 400 that is disposed between the supporting substrate 200 and main substrate 300, a supporting member 500 that is provided between the intermediate substrate 400 and supporting substrate 200 and holds the supporting substrate 200 such that the supporting substrate 200 is inclinable, and elastic members 600 provided (at 8 locations) between the supporting member 200 and intermediate substrate 400. Hereinafter, each part of the probe card will be described in detail.

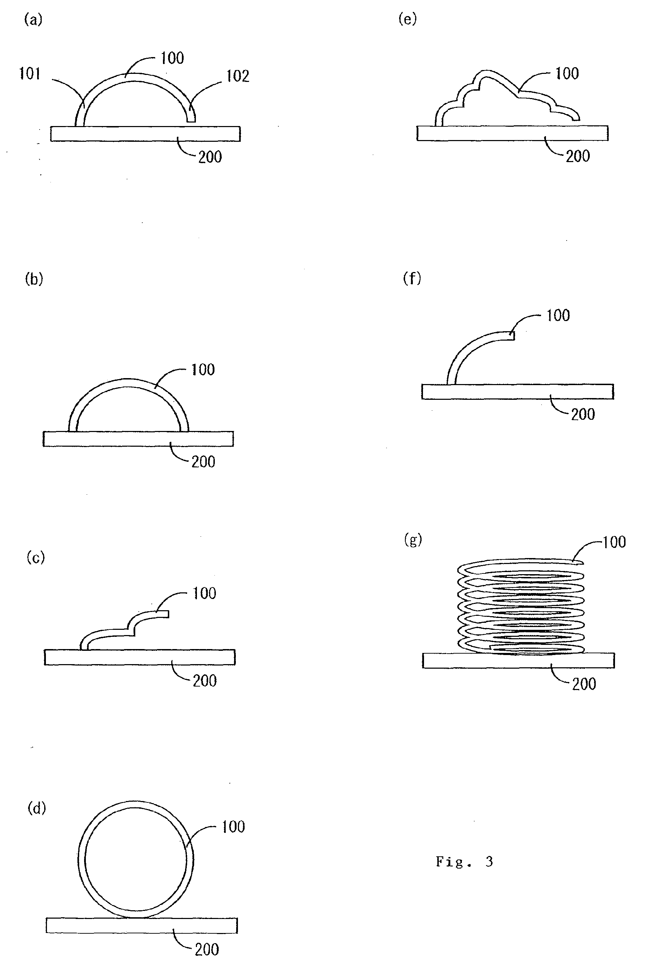

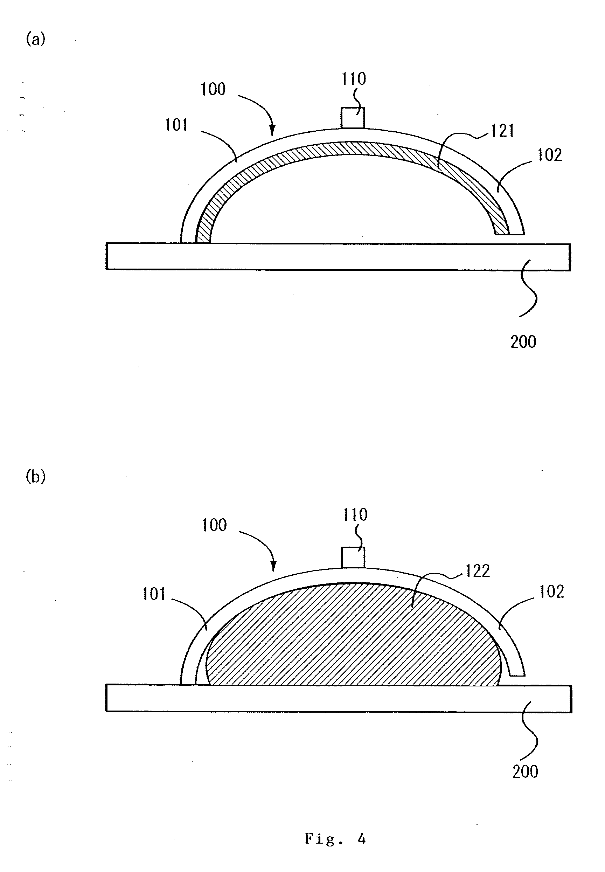

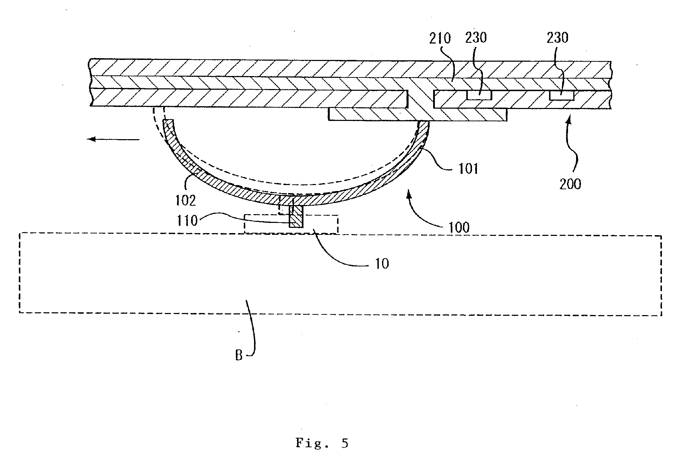

The probes 100 have a shape that allows elastic deformation at least in vertical directions so as to absorb variations in height of contactable signal electrodes 10 of the object B to be measured. Examples include: a cantilever-shaped, semicircular-arc-shaped probe formed on one surface of the supporting substrate 200 shown in Fig. 3(a); a circular-arc-shaped probe with both ends thereof connected to the supporting substrate 200 shown in Fig. 3(b); a cantilever-shaped probe having plural sections that are curved in a direction of length of the supporting substrate 200 shown in Fig. 3(c); a circular-shaped probe with both ends thereof connected to the supporting substrate 200 shown in Fig. 3(d); a cantilever-shaped probe having plural curved sections shown in Fig. 3(e); a cantilever-shaped probe having a section curved in a direction of length of the supporting substrate 200 shown in Fig. 3(f); and a coil spring- shaped probe shown in Fig. 3(g). As shown in Figs. 4 and 5, a projection-shaped contact terminal 110 which is brought into contact with the signal electrode 10 of the object B to be measured can be provided approximately at the center top of the probe 100.

This probe 100 is integrally formed on the lower surface of the supporting substrate 200 by repeating a process of coating a resist on the lower surface of the supporting substrate 200, forming a pattern on the resist and then forming a plating on the pattern. The pitch of this probe 100 is adjusted to the same value (in this case, 25 µm) as that of the signal electrode 10 of the object B to be measured so that the probe 100 can contact the signal electrode 10 of the object B to be measured.

When the probe 100 has a curved, cantilever shape (i.e. probes shown in Figs. 3(a), 3(c), 3(e) and 3(f)), one or more layers of reinforcing member 121 of alumina or the like having a higher elasticity than the probe 100 can be integrally provided, as shown in Fig. 4(a), along a direction of length of that surface of the probe 100 that faces the supporting substrate 200. When the probe 100 has a curved shape and there exists a gap between the supporting substrate 200 and the opposite surface of that top of the probe 100 that contacts the signal electrode 10 of the object B to be measured (i.e. probes shown in Figs. (a) to (f)), a reinforcing member 122 of elastomer or the like having a higher elasticity than the probe 100 can be interposed in the gap as shown in Fig. 4(b). The reinforcing member 121 is integrally formed in a manufacturing process of the probe 100 by coating alumina or the like on that surface of the probe 100 that faces the supporting substrate 200. Similarly, the reinforcing member 122 is interposed in the gap in the manufacturing process of the probe 100 by filling elastomer or the like into the gap.

Hereinafter, for the convenience of the explanation, the probe 100 will be described by using the cantilever-shaped, semicircular-arc-shaped probe shown in Figs. 3(a), 4 and 5 as an example. The probe 100 has a configuration comprising a first quarter-circular-arc-shaped section 101 with one end thereof supported by the supporting substrate 200 and a second quarter-circular-arc-shaped section 102 that is linked to the other end of the first quarter-circular-arc-shaped section 101 and is slightly shorter than the first quarter-circular-arc-shaped section 101. The projection-shaped contact terminal 110 is provided approximately at the center top of the probe 100.

The supporting substrate 200 is composed of an insulative material that has a linear expansion coefficient close to that of the object B to be measured. Examples include a substrate of silicon and a substrate of polymer. In this way, due to the use of the material that has a linear expansion coefficient close to that of the object B to be measured, even when the measurement is performed by shifting the temperature of measurement environment over a wide range, the supporting substrate 200 can be expanded or contracted similarly to the object B to be measured being expanded or contracted. Specifically, with the probe 100 formed on the surface of the supporting substrate 200, it becomes possible to cope with a displacement of the signal electrode 10 associated with the expansion or contraction of the object B to be measured.

As shown in Figs. 1 and 5, a wiring pattern 210 is formed inside and/or on the surface of the supporting substrate 200. Also, connectors 220 are provided at the edge of the upper surface of the supporting substrate 200 (refer to Fig. 1). One end of the wiring pattern 210 is exposed on the lower surface of the supporting substrate 200 to be electrically connected to each probe 100; the other end is electrically connected to the connectors 220. The connectors 220 are electrically connected to flexible substrates 720 of a connecting member 700 described later.

Also, circuit elements 230 electrically connected to the wiring pattern 210 are provided inside the supporting substrate 200 (refer to Fig. 5). These circuit elements 230 are needed to perform the electrical measurement using the probes. A capacitor working as a so-called bypass capacitor and a circuit element having a function of BOST (Build out self test) that supplements the test (i.e. measurement of the electrical properties of the object B to be measured) are employed here. The capacitor plays a role of improving the high-frequency characteristics. The circuit element having a function of BOST plays a different role according to the test contents of the object B to be measured.

A reinforcing board 240 is attached to the upper surface of the supporting substrate 200. A material that is more rigid than the supporting substrate 200 and has a linear expansion coefficient close to that of the object B to be measured, for example, molybdenum or the like is used for constructing the reinforcing board 240. Through holes (not shown) into which connecting probes 710 of the connecting member 700 are inserted are formed in the supporting substrate 200 and reinforcing board 240.

As the intermediate substrate 400, a ceramic substrate or the like that is more rigid than the main substrate 300 is employed, for example. The intermediate substrate 400 is mounted on the prober by using screw fixing so as to be disposed between the main substrate 300 and supporting substrate 200. Through holes (not shown) into which connecting probes 710 of the connecting member 700 are inserted are formed in the intermediate substrate 400.

The supporting member 500 being a vertically elastically deformable damper includes a columnar body 510 and a coil spring 520 attached to the columnar body 510. The columnar body 510 is provided at the center of the supporting substrate 200 and attached to the center of the intermediate substrate 400. Accordingly, one end of the columnar body 510 is disposed at the center of the supporting substrate 200 to thereby work as a supporting point of the supporting substrate 200. Thus, the supporting substrate 200 can be held so as to be inclinable.

Vertically elastically deformable coil springs having a smaller overall spring coefficient than that of the probes 100 are employed as the elastic members 600. Accordingly, when one part of the probes 100 contacts one part of the signal electrodes 10 positioned higher than the other signal electrodes 10 of the object B to be measured, the supporting substrate 200 will incline around the supporting member 500. Accordingly, the elastic members 600 will elastically deform before the probes 100 do. Specifically, by elastically deforming according to the inclination of the supporting substrate 200, the elastic members 600 play a role of absorbing the inclination of the object B to be measured.

As the main substrate 300, a flexible substrate is employed. The main substrate 300 is attached in an extended state to the screws for mounting the intermediate substrate 400 on the prober. Inside the main substrate 300, there is formed a wiring pattern 310. At the edge of the upper surface of the main substrate 300, there are provided external electrodes 320 electrically connected to the wiring pattern 310. On the lower surface of the main substrate 300, there is exposed the wiring pattern 310. The rear ends of the connecting probes 710 of the connecting member contact the exposed wiring pattern 310. The external electrodes 320 are electrically connected to the power supply unit of the measurement apparatus.

Regarding the connecting member 700, the connecting probes 710 are used for the power lines; the flexible substrates 720 are used for the measurement signal lines. The tip ends of the connecting probes 710 are inserted into the through holes of the supporting substrate 200 and reinforcing board 240, and contact the electrode for power supply (not shown) of the object B to be measured; the rear ends of the connecting probes 710 are inserted into the through holes of the intermediate substrate 400, and contact the wiring pattern 310 being exposed from the lower surface of the main substrate 300. The flexible substrates 720 electrically connect the connectors 220 of the supporting substrate 200 and the measurement unit of the measurement apparatus. In the connecting probes 710, there is provided a bending part. The bending part is bent so that the elastic deformation of the supporting member 500 and elastic members 600 is not impeded.

Specifically, an operation signal outputted from the power supply unit of the measurement apparatus sequentially flows through the external electrodes 320 of the main substrate 300 and the wiring pattern 310 to the connecting probes 710. On the other hand, a measurement signal outputted from the measurement unit of the measurement apparatus sequentially flows through the flexible substrates 720, the connectors 220 of the supporting substrate 200 and the wiring pattern 210 to the probes 100.

In the probe card A having such a configuration, the supporting member 500 provided on the supporting substrate 200 is attached to the intermediate substrate 400. Then, the elastic members 600 are installed between the intermediate substrate 400 and supporting substrate 200. Subsequently, the connecting probes 710 are sequentially inserted into the through holes of the intermediate substrate 400, supporting substrate 200 and reinforcing board 240. Then, the intermediate substrate 400 is directly mounted on the prober of the measurement apparatus by using screw fixing. Then, the main substrate 300 is attached to the screws and the connecting probes 710 are brought into contact with the wiring pattern 310 of the main substrate 300. Subsequently, the flexible substrates 720 are brought into contact with the connectors 220 of the supporting substrate 200 and the connector of the measurement apparatus.

In this way, the probe card A is mounted on the prober of the measurement apparatus to be used to measure the electrical properties of the object B to be measured. Hereinafter, the use of the probe card A will be described in detail. In this case, assume that the object B to be measured is in an inclined state.

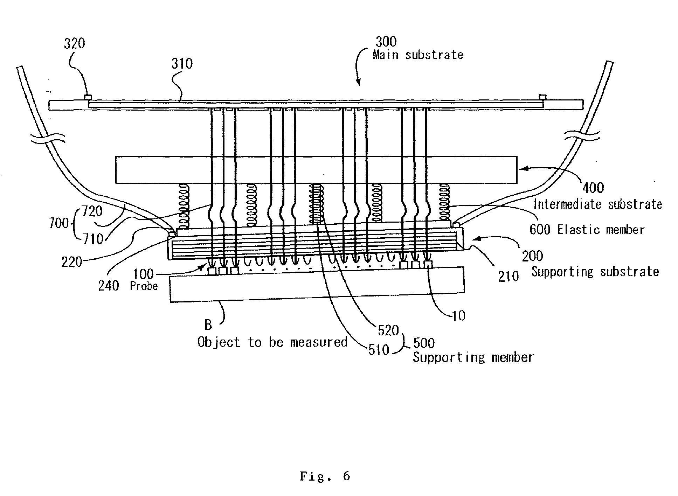

Firstly the driving unit of the prober is activated to make the position adjustment between the probe card A and the object B to be measured. Then, the probe card A is brought relatively close to the object B to be measured so that the connecting probes 710 contact the electrode for power supply of the object B to be measured. At the same time, the connecting terminals 110 of the probes 100 are brought into contact with the signal electrodes 10 of the object B to be measured. In this process, when one part of the connecting terminals 110 of the probes 100 contact one part of the signal electrodes 10 positioned higher than the other signal electrodes 10 of the object B to be measured, then the coil springs 520 of the supporting member 500 and the elastic members 600 will deform elastically as shown in Fig. 6 and at the same time the supporting substrate 200 will incline around the supporting member 500 in accordance with the inclination of the object B to be measured. Accordingly, the supporting substrate 200 is positioned parallel to the object B to be measured so that all the connecting terminals 110 of the probes 100 contact the signal electrodes 10 of the object B to be measured. Subsequently, the probe card A and the object B to be measured are further brought relatively closer to each other to press (i.e. overdrive) the connecting terminals 110 of the probes 100 against the signal electrodes 10 of the object B to be measured. In this process, the coil springs 520 of the supporting member 500 and the elastic members 600 deform elastically (i.e. contract) and at the same time each of the probes 100 deforms elastically according to the variations in height of each signal electrode 10 of the object B to be measured. Accordingly, the connecting terminals 110 of the probes 100 are pressed against the signal electrodes 10 of the object B to be measured. Thus, a predetermined contact pressure needed to achieve the electrical continuity between the probes 100 and the signal electrodes 10 of the object B to be measured can be secured.

At this time, as shown in Fig. 5, while the probe 100 deforms elastically, the tip of the second quarter-circular-arc-shaped section 102 contacts the surface of the supporting substrate 200 and then moves on the above surface of the supporting substrate 200 (in the direction of arrow in Fig. 5). When the probe 100 is operated in this way, the load introduced on the probe 100 by the overdriving can be reduced to prevent the probe 100 from being damaged, and at the same time a given scrub is produced on the probe 100 to peel the oxide film off the signal electrode 10, thereby making it possible to achieve a stable contact with the signal electrode 10.

Thereafter, when the measurement of the object B to be measured using the measurement apparatus is finished, the driving unit of the prober is activated to detach the probe card A from the object B to be measured.

In the foregoing probe card A, even if the object B to be measured is in an inclined state, when one part of the probes 100 contact one part of the signal electrodes 10 positioned higher than the other signal electrodes 10 of the object B to be measured, the supporting substrate 200 will incline around the supporting member 500 according to the inclination of the object B to be measured. Thus, the supporting substrate 200 is positioned parallel to the object B to be measured and then all the probes 100 are brought into contact with the signal electrodes 10, thereby performing the measurement with a predetermined contact pressure. Consequently, a conventional case can be avoided in which while one part of the probes 100 can contact one part of the signal electrodes of the object B to be measured, the remaining probes 100 fail to contact the other signal electrodes 10, or even if there exists some contact, a predetermined contact pressure needed to achieve the electrical continuity between the probes 100 and signal electrodes 10 can not be obtained. Thus, the measurement can be properly performed.

### Embodiment 2

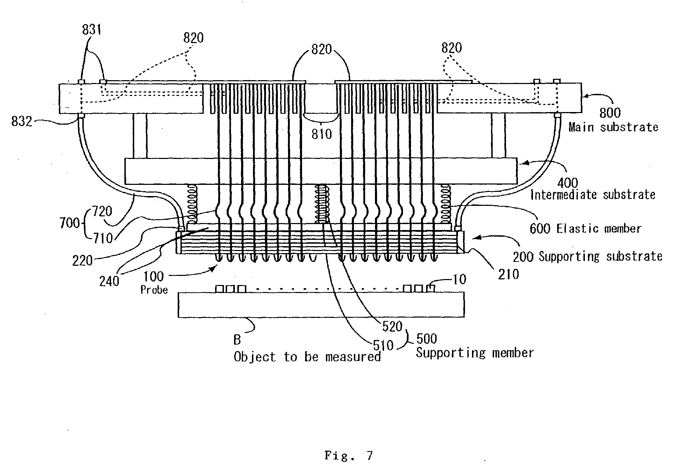

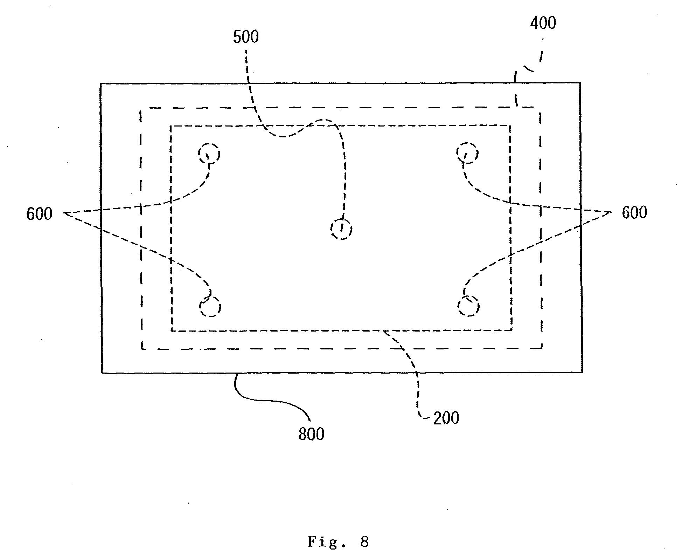

A probe card according to a second embodiment of the invention will now be described with reference to Figs. 7 and 8.

The probe card A' shown in Figs. 7 and 8 has a configuration substantially similar to that of the probe card A. A large difference between the probe cards A and A' is that a printed circuit board is employed as a main substrate 800 of the probe card A'. Hereinafter, the difference will be described in detail, and repeated explanation of overlapping parts is omitted here. While reference numeral 800 designates the main substrate, the same reference numerals are applied to the other parts corresponding to Embodiment 1.

In the main substrate 800, there are provided a plurality of through holes 810 into which connecting probes 710 are inserted. Inside and/or on the surface of the main substrate 800, there is formed a wiring pattern 820. Also, at the edge of the upper surface of the main substrate 800, there are provided external electrodes 831. These external electrodes 831 are electrically connected to the power supply unit or measurement unit of the measurement apparatus. At the edge of the lower surface of the main substrate 800, there are provided connecters 832 electrically connected to flexible substrates 720. The wiring pattern 820 electrically connects the external electrodes 831 and the rear ends of the connecting probes 710 inserted into the through holes 810, and at the same time electrically connects the external electrodes 831 and the connectors 832.

The flexible substrates 720 of the connecting member 700 is used to electrically connect connectors 220 of a supporting substrate 200 and connecters 832 of the main substrate 800.

Specifically, an operation signal outputted from the power supply unit of the measurement apparatus sequentially flows through the external electrodes 831 of the main substrate 800 and the wiring pattern 810 to the connecting probes 710. On the other hand, a measurement signal outputted from the measurement unit of the measurement apparatus sequentially flows through the external electrodes 831 of the main substrate 800, the wiring pattern 810, the connectors 832, the flexible substrates 720, the connectors 220 of the supporting substrate 200 and the wiring pattern 210 to the probes 100.

The intermediate substrate 400 is mounted on the main substrate 800 by using screw fixing to be disposed between the main substrate 800 and supporting substrate 200.

Hereinafter, the use of the probe card A' will be described in detail with reference to Figs. 5 and 6. In this case, assume that the object B to be measured is in an inclined state.

Firstly the driving unit of the prober is activated to make the position adjustment between the probe card A and the object B to be measured. Then, the probe card A is brought relatively close to the object B to be measured so that the connecting probes 710 contact the electrode for power supply of the object B to be measured. At the same time, the connecting terminals 110 of the probes 100 are brought into contact with the signal electrodes 10 of the object B to be measured. In this process, when one part of the connecting terminals 110 of the probes 100 contact one part of the signal electrodes 10 positioned higher than the other signal electrodes 10 of the object B to be measured, then the coil springs 520 of the supporting member 500 and the elastic members 600 will deform elastically as shown in Fig. 6 and at the same time the supporting substrate 200 will incline around the supporting member 500 in accordance with the inclination of the object B to be measured. Accordingly, the supporting substrate 200 is positioned parallel to the object B to be measured so that all the connecting terminals 110 of the probes 100 contact the signal electrodes 10 of the object B to be measured. Subsequently, the probe card A and the object B to be measured are further brought relatively closer to each other to press (i.e. overdrive) the connecting terminals 110 of the probes 100 against the signal electrodes 10 of the object B to be measured. In this process, the coil springs 520 of the supporting member 500 and the elastic members 600 deform elastically (i.e. contract) and at the same time each of the probes 100 deforms elastically according to the variations in height of each signal electrode 10 of the object B to be measured. Accordingly, the connecting terminals 110 of the probes 100 are pressed against the signal electrodes 10 of the object B to be measured. Thus, a predetermined contact pressure needed to achieve the electrical continuity between the probes 100 and the signal electrodes 10 of the object B to be measured can be secured.

At this time, while the probe 100 deforms elastically, the tip of the second quarter-circular-arc-shaped section 102 contacts the surface of the supporting substrate 200 and then moves on the above surface of the supporting substrate 200 (refer to Fig. 5). When the probe 100 is operated in this way, the load introduced on the probe 100 by the overdriving can be reduced to prevent the probe 100 from being damaged, and at the same time a given scrub is produced on the probe 100 to peel the oxide film off the signal electrode 10, thereby making it possible to achieve a stable contact with the signal electrode 10.

Thereafter, when the measurement of the object B to be measured using the measurement apparatus is finished, the driving unit of the prober is activated to detach the probe card A from the object B to be measured.

Even with the prove card A' like this, similarly to the prove card A, even if the object B to be measured is in an inclined state, when one part of the probes 100 contact one part of the signal electrodes 10 positioned higher than the other signal electrodes 10 of the object B to be measured, the supporting substrate 200 will incline around the supporting member 500 according to the inclination of the object B to be measured. Thus, the supporting substrate 200 is positioned parallel to the object B to be measured and then all the probes 100 are brought into contact with the signal electrodes 10, thereby performing the measurement with a predetermined contact pressure. Consequently, a conventional case can be avoided in which while one part of the probes 100 can contact one part of the signal electrodes of the object B to be measured, the remaining probes 100 fail to contact the other signal electrodes 10, or even if there exists some contact, a predetermined contact pressure needed to achieve the electrical continuity between the probes 100 and signal electrodes 10 can not be obtained. Thus, the measurement can be properly performed.

Any design modification to the probe cards A and A' can be performed under the condition that the probe card includes: the probes shape that allows a vertical elastic deformation; a supporting substrate with the probes provided on the lower surface thereof; a main substrate positioned opposite the upper surface of the supporting substrate; and a column-shaped supporting member that is provided between the supporting substrate and main substrate and holds the supporting substrate such that the supporting substrate is inclinable, wherein one end of the supporting member is disposed at the center of the supporting substrate.

Accordingly, when a rigid substrate like the main substrate 800 is employed as the main substrate, it is not necessary to provide an intermediate substrate 400. (However, when a flexible substrate like the main substrate 300 is employed, then the intermediate substrate 400 is indispensable.) In this case, the supporting member 500 and elastic members 600 are disposed between the main substrate and supporting substrate 200. In this configuration, as the main substrate, there is preferably employed a substrate having a rigidity such that the substrate is prevented from being bent by a pushing force exerted through the supporting member 500 and elastic members 600 when the probes 100 are brought into contact with the signal electrodes 10. However, even a substrate without such rigidity can be used when it is reinforced with a reinforcing board or the like.

In this embodiment, a PCB is employed as the main substrate 800. However, any substrate can be used on the condition that the same function can be implemented. When a wiring pattern or the like is not provided on the main substrate 300, a simple board-like body can be employed. In this case, the connecting member 700 is directly connected electrically to the measurement apparatus.

In this embodiment, a vertically elastically deformable damper is employed as the supporting member 500. However, any member can be used on the condition that it is a column-shaped body for holding the supporting substrate such that the supporting substrate is inclinable. For example, a rigid column-shaped rubber piece or the like having a larger overall spring coefficient than that of the probes 100 and elastic members 600 can be employed.

The elastic members 600 are preferably provided at at least two locations. However, the elastic members 600 can be omitted.

Regarding the connecting member 700, the connecting probes 710 are used for the power lines; the flexible substrates 720 are used for the signal lines. However, of course, the connecting probes 710 can be used for the signal lines; the flexible substrates 720 can be used for the power lines. The connecting probes 710 may be provided arbitrarily. When the connecting probes 710 are not provided, the flexible substrates 720 double as the power lines and measurement signal lines.

## Claims

1. A probe card comprising:
probes shaped to allow vertical elastic deformation,
a supporting substrate with the probes provided on a lower surface thereof,
a main substrate opposing an upper surface of the supporting substrate, and
a column-shaped supporting member that is provided between the supporting substrate and the main substrate and holds the supporting substrate so that the supporting substrate is inclinable, wherein one end of the supporting member is disposed at a center of the supporting substrate.

2. The probe card according to claim 1, wherein the supporting member has a configuration for allowing vertical elastic deformation.

3. The probe card according to claim 1 or 2, wherein vertically elastically deformable elastic members are provided at at least two locations between the supporting substrate and the main substrate, an overall spring coefficient of the elastic members being smaller than that of the probes.

4. The probe card according to claim 1, 2 or 3, wherein an intermediate substrate being more rigid than the main substrate is disposed between the main substrate and supporting substrate, and
the supporting member, or the supporting member and the elastic members are provided between the intermediate substrate and the supporting substrate.

5. The probe card according to claim 4, wherein a wiring pattern electrically connected to the probes is formed at least one of inside, on the upper surface and on the lower surface of the supporting substrate.

6. The probe card according to claim 5, wherein circuit elements are provided at least one of inside, on the upper surface and on the lower surface of the supporting substrate, the circuit elements being electrically connected to the wiring pattern.

7. The probe card according to claim 5, wherein a wiring pattern is formed at least one of inside, on the upper surface and on the lower surface of the main substrate, the wiring pattern of the main substrate being electrically connected via a connecting member to the wiring pattern of the supporting substrate.

8. The probe card according to claim 5, wherein the main substrate is a flexible substrate,
a wiring pattern electrically connected to the probes is formed at least one of inside, on the upper surface and on the lower surface of the main substrate, and
the wiring pattern of the main substrate is electrically connected via the connecting member to the wiring pattern of the supporting substrate.

9. The probe card according to claim 5 or 8, wherein a reinforcing board is provided on the upper surface of the supporting substrate.
